# EUROPÄISCHE PATENTSCHRIFT

(11) **EP 1 517 362 B1**
(45) Veröffentlichungstag und Bekanntmachung des Hinweises auf die Patenterteilung: **20.02.2008**
(21) Anmeldenummer: 04022112.9
(22) Anmeldetag: 17.09.2004
(51) Int. Cl.: H01L 21/336, H01L 21/225, H01L 29/78, H01L 29/786, H01L 21/265, H01L 29/08

(54) **Verfahren zur Herstellung von Halbleiterbauelementen in einem Halbleitersubstrat**
Method of making semiconductor devices in a semiconductor substrate
Méthode de fabrication de dispositifs semi-conducteurs dans un substrat semiconducteur

(30) Priorität: 19.09.2003 DE 10345345
(43) Veröffentlichungstag der Anmeldung: 23.03.2005
(73) Patentinhaber: ATMEL Germany GmbH, 74072 Heilbronn (DE)
(72) Erfinder: Dietz, Franz, Dipl.-Ing. (FH), 74081 Heilbronn (DE); Dudek, Volker, Dr., 74336 Brackenheim (DE); Graf, Michael, Dr., 71397 Leutenbach (DE)
(74) Vertreter: Müller, Wolf-Christian

(56) Entgegenhaltungen:
- EP-A- 1 271 638
- WO-A-86/03339
- MEYER W G ET AL: "INTEGRABLE HIGH VOLTAGE CMOS: DEVICES, PROCESS APPLICATION" INTERNATIONAL ELECTRON DEVICES MEETING, TECHNICAL DIGEST, WASHINGTON, DC, USA, DECEMBER 1-4, 1985, 1. Dezember 1985 (1985-12-01), - 4. Dezember 1985 (1985-12-04) Seiten 732-735, XP002008457 IEEE, NEW YORK, NY, USA

## Beschreibung

Die Erfindung betrifft ein Verfahren zur Herstellung von Halbleiterbauelementen in einem Halbleitersubstrat mit den Schritten: Erzeugen von Wannen mit unterschiedlichem Leitfähigkeitstyp und Erzeugen von grabenförmigen Strukturen innerhalb des Halbleitersubstrates, wobei die Wannen durch eine Implantation und eine Eindiffusion von Dotierstoffen erzeugt werden, und Erzeugen und Kontaktieren von aktiven Bereichen in dem Halbleitersubstrat.

Eine Wanne ist ein dreidimensionaler Teilbereich des Halbleitersubstrates, dessen Majoritätsladungsträger von einem anderen Typ (z.B. P) sind als die Majoritätsladungsträger in der Umgebung der Wanne (z.B. N). Als Folge bilden sich an den Grenzen der Wannen bei entsprechender Polung sperrende PN-Übergänge aus, die das Innere der Wanne elektrisch von ihrer Umgebung isolieren.

Grabenförmige Strukturen in einem Halbleitersubstrat werden zum Beispiel zur elektrischen Isolierung von sogenannten Bauelementboxen in der Tiefe und/oder an der Oberfläche des Halbleitersubstrates oder zur dreidimensionalen Gestaltung elektrisch wirksamer Bereiche (zum Beispiel eines Grabenkondensators oder einer Driftzone) innerhalb des Halbleitersubstrats verwendet. Zur elektrischen Isolierung in der Tiefe werden in der Regel tiefe Gräben (deep trenches) verwendet, während für die dreidimensionale Gestaltung elektrisch wirksamer Bereiche und auch für Isolierungsaufgaben an der Oberfläche flache Gräben bevorzugt werden. Tiefe Gräben und flache Gräben lassen sich durch das Verhältnis von Tiefe zu Breite, das Aspektverhältnis, unterscheiden, das bei tiefen Gräben größer als eins und bei flachen Gräben kleiner als eins ist. Mit anderen Worten: Tiefe Gräben sind tiefer als breit. Flache Gräben sind breiter als tief.

Beispiele von aktiven Bereichen sind einzelne Transistoren, die in das gleiche Substrat integriert sind. Einzelne aktive Bereiche werden durch Feldbereiche voneinander getrennt, so dass sich die Oberfläche des Halbleitersubstrates in aktive Bereiche und dazu komplementäre Feldbereiche aufteilen lässt.

Ein solches Verfahren ist, für den speziellen Fall der Herstellung eines DMOS-Transistors als Halbleiterelement, aus der DE 101 31 705 A1 bekannt.

Um eine unerwünschte Drift von Ladungsträgern wie Elektronen oder Löchern zwischen den aktiven Bereichen zu vermeiden, werden die Feldbereiche mit isolierenden Strukturen versehen. Bei auf der Siliziumtechnologie basierenden integrierten Schaltungen ist es bekannt, aktive Bereiche an der Oberfläche der Schaltung durch eine aus Siliziumoxid bestehende, meist Feldoxid genannte Isolationsstruktur zu isolieren.

Für eine Isolierung aktiver Bereiche in der Tiefe der Struktur der integrierten Schaltung werden alternativ oder ergänzend zu den tiefen Gräben Wannen für die laterale Isolierung verwendet. Die Wannen werden in der Regel durch Implantieren eines Dotierstoffes und thermisch unterstützte Eindiffusion des Dotierstoffes erzeugt. Da sich bei der Eindiffusion in der Regel keine Vorzugsrichtung ausbildet, findet die Eindiffusion sowohl in die Tiefe als auch in die Breite statt. Je tiefer die Wannen in Hochtemperaturschritten in das Halbleitersubstrat, beispielsweise Silizium, eingetrieben werden (Wannen-Drive), desto größer ist die laterale Ausdehnung der Wannen und deren gegenseitige Beeinflussung durch Ausdiffusion. Dabei versteht man unter einer Ausdiffusion eine Verringerung einer Nettokonzentration der Dotierstoffe am Rand einer Wanne durch eine laterale Diffusion von Dotierstoffen aus einer entgegengesetzt dotierten Nachbarwanne.

Bei dem aus der DE 101 31 705 A1 bekannten Verfahren erfolgt eine Definition von Wannen, also eine oberflächennahe Implantation von Dotierstoffen und eine anschließende, vollständige Eindiffusion in das Substratvolumen, vor einem Erzeugen tiefer Gräben, die Bauelementboxen innerhalb des Substrates definieren. Weiter wird nach der DE 101 31 705 A1 eine Driftzone des DMOS-Transistors durch gesondert dotierte Randgebiete einer weiteren Grabenstruktur definiert, die durch eine STI-Ätzung (STI = shallow trench isolation) erzeugt wird.

Bei der auf diese Weise erfolgenden Definition der Wannen vor einer Erzeugung von Gräben kann es insbesondere dann zu der beschriebenen Ausdiffusion kommen, wenn hohe Dotierstoffkonzentrationen und/oder große Eindringtiefen erzeugt werden sollen. Um diese unerwünschte Ausdiffusion auszuschließen, müssen die Abstände elektrisch aktiver Gebiete mit unterschiedlichen Wannendotierungen entsprechend groß gewählt werden, was letztlich zu unerwünschten Beschränkungen der Packungsdichte führt. Mit anderen Worten: Die dann erforderliche laterale Ausdehnung der Wannen erfordert eine laterale Mindestbreite der Struktur, die eine weitere Strukturverkleinerung begrenzt.

Vor diesem Hintergrund besteht die Aufgabe der Erfindung in der Angabe eines Verfahrens zur Herstellung eines Halbleiterbauelements, das eine weitere Strukturverkleinerung erlaubt.

Diese Aufgabe wird bei einem Verfahren der eingangs genannten Art dadurch gelöst, dass die Eindiffusion durch wenigstens zwei Hochtemperaturschritte erfolgt, wobei wenigstens ein erster Hochtemperaturschritt vor einem Erzeugen der grabenförmigen Strukturen durchgeführt wird und wobei wenigstens ein zweiter Hochtemperaturschritt nach dem Erzeugen der grabenförmigen Strukturen durchgeführt wird.

Für eine Betrachtung der Vorteile dieser Aufteilung und Anordnung der Hochtemperaturschritte relativ zu einer Grabenbildung ist zu berücksichtigen, dass eine vollständig nach einer Grabenerzeugung erfolgende Eindiffusion der Wannendotierung, wie aus der WO-A-86/03339 bekannt, zwar einerseits eine Ausdiffusion in äußeren Randbereichen der Wanne verhindern könnte. Andererseits besteht dann, wenn die tiefen Gräben vor Hochtemperaturschritten eines Wannen-Drives geätzt werden, grundsätzlich das Problem, dass wegen der hohen thermischen Belastung am Rand der Grabenisolation Defekte auftreten können. Diese Defekte können in einem späteren Betrieb des Halbleiterelements zu hohen, unerwünschten Leckströmen führen, die eine Durchbruchspannung unerwünscht verringern.

Es ist gerade das erfindungsgemäße Aufteilen der Diffusion der Wannendotierung auf verschiedene Hochtemperaturschritte und das zeitlich getrennte Ausführen von Hochtemperaturschritten, die durch wenigstens einen Schritt des Erzeugens von Grabenstrukturen getrennt sind, das einen tragfähigen Kompromiss zwischen an sich gegensätzlichen Forderungen nach einer weitgehenden Verhinderung einer Ausdiffusion in äußeren Randbereichen einer Wanne und Forderungen nach der Vermeidung kritischer Leckstromraten im späteren Betrieb liefert. Dabei resultiert die erste Forderung aus dem Bestreben nach einer weiteren Strukturverkleinerung, während die zweite Forderung mit dem Verlangen nach einem hohen Durchbruchwiderstand zusammenhängt.

Es ist bevorzugt, dass wenigstens ein Teil der grabenförmigen Strukturen durch tiefe Gräben gebildet wird, die Bauelementboxen voneinander isolieren, die innerhalb des Halbleitersubstrates angeordnet sind.

Auf diese Weise wird die laterale Diffusion von Wannen-Dotierstoffen durch die Grabenstrukturen beschränkt. Daher können kleine Wannengebiete mit hohen und/oder tief in ein Volumen des Halbleitersubstrates hinabreichenden Dotierstoffkonzentrationen erzeugt werden, ohne dass an den Rändern der Wannen eine unerwünschte laterale Diffusion auftritt.

Eine solche unerwünschte laterale Diffusion wird durch die Gräben verhindert.

Bevorzugt ist auch, dass die tiefen Gräben bis hinunter zu einer Isolierschicht reichen, auf der sich das Halbleitersubstrat erstreckt.

Durch diese Maßnahme können die Wannen nicht nur an der Oberfläche, sondern auch im Volumen des Halbleitersubstrates definiert voneinander getrennt und damit isoliert werden.

Ferner ist bevorzugt, dass wenigstens ein Teil der grabenförmigen Strukturen durch flache Gräben gebildet wird, die eine Driftzone eines DMOS-Transistors teilweise begrenzen.

Ein DMOS-Transistor zeichnet sich gegenüber einem herkömmlichen MOS Transistor (Metal-Oxid Semiconductor Transistor) dadurch aus, dass zwischen einer Kante eines Steuer-Gates und einem Drain-Bereich des Transistors eine Driftzone vorgesehen ist, d. h. eine Zone, in der die Bewegung der Ladungsträger nur durch ein zwischen den gegenüberliegenden Enden der Zone herrschendes elektrisches Feld bewirkt wird. Durch die Gestaltung der Driftzone an den Rändern eines flachen Grabens, insbesondere an dessen Seitenwänden, lässt sich die laterale Ausdehnung der Driftzone verringern.

Eine weitere bevorzugte Ausgestaltung sieht vor, dass die flache grabenförmige Struktur durch einen STI-Prozess erzeugt wird.

Bei der "shallow trench isolation"-Technologie werden durch einen anisotropen Ätzprozess Gräben zwischen mit einer Nitridschutzschicht bedeckten aktiven Bereichen erzeugt und mit einem isolierenden Material wie Siliziumdioxid oder Polysilizium aufgefüllt. Mit der STI-Technologie lassen sich, zum Beispiel im Vergleich zu einer V-Grabenätzung mit einer LOCOS-Maske, höhere Packungsdichten erzielen.

Bevorzugt ist auch, dass Seitenwände und/oder Bodenbereiche der grabenförmigen Struktur gesondert dotiert werden.

Durch diese Ausgestaltung lässt sich das Dotierstoffprofil der Driftzone im Hinblick auf die gewünschten Eigenschaften wie hohe Durchbruchspannung, niedrige Einschaltspannung und RESURF-Effekt (reduced surface field Effekt) optimieren.

Eine weitere bevorzugte Ausgestaltung zeichnet sich dadurch aus, dass die gesonderte Dotierung durch wenigstens eine vor dem zweiten Hochtemperaturschritt erfolgende Implantation und eine während des zweiten Hochtemperaturschrittes erfolgende Eindiffusion erfolgt.

Dadurch erfolgt ein Teil der Eindiffusion der Wannendotierung gezielt gemeinsam mit einer Eindiffusion der Driftzonendotierung. Als Folge kann auf einen separaten Hochtemperaturschritt zur Eindiffusion der Driftzonendotierung verzichtet werden, was die Verfahrensdauer abkürzt. In Verbindung mit dem erfindungsgemäßen Aufteilen und Anordnen der Diffusionsschritte können durch diese Merkmale die Dotierungen im Bereich der Driftzone der DMOS-Transistoren optimal unter der flachen Grabenstruktur (STI) eingestellt werden.

Bevorzugt ist auch, dass eine Implantation eines zweiten Dotierstoffes für eine zweite Wanne in einen zweiten Bereich erfolgt, der einen lateralen Abstand zu einem ersten Bereich besitzt, in den eine Implantation eines ersten Dotierstoffes für eine erste Wanne erfolgt. Ferner ist bevorzugt, dass die Eindiffusion so erfolgt, dass zwischen den Wannen nach den Hochtemperaturschritten ein Bereich intrinsischer Leitfähigkeit bestehen bleibt.

Diese Merkmale verringern einzeln oder in Kombination miteinander eine Kompensation der unterschiedlichen Dotierungen benachbarter Wannengebiete nach innen und tragen so zu einer gewünschten Erhöhung der Durchbruchspannung auf mehr als 80 Volt bei.

Eine weitere bevorzugte Ausgestaltung sieht vor, dass die grabenförmigen Strukturen mit einem Dielektrikum gefüllt werden.

Dabei ist besonders bevorzugt, dass als Dielektrikum ein Oxid des Halbleitersubstratmaterials, ein Nitrid des Halbleitersubstratmaterials, polykristallines Material aus Bestandteilen des Halbleitersubstratmaterials oder ein Mehrschichtsystem aus den genannten Materialien verwendet wird.

Diese Materialien besitzen eine gute Isolationswirkung und gehen ausreichend temperaturfeste und schwingungsunempfindliche und damit dauerfeste Verbindungen mit dem Material des Halbleitersubstrates ein.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfmdung zu verlassen.

### Zeichnungen

Ausführungsbeispiele der Erfindung sind in den Zeichnungen dargestellt und werden in der nachfolgenden Beschreibung näher erläutert. Es zeigen, jeweils in der Form schematischer Querschnitte:
- Fig. 1: ein Halbleitersubstrat während einer Implantation eines ersten Dotierstoffs;
- Fig. 2: das Halbleitersubstrat nach einer Implantation von Dotierstoffen als Basis einer Definition von zwei Wannen im Halbleitersubstrat;
- Fig. 3: das Halbleitersubstrat nach einem ersten Hochtemperaturschritt zur noch unvollständigen Eindiffusion der Wannendotierungen;
- Fig. 4: das Halbleitersubstrat nach einer deep trench Ätzung zu Beginn eines zweiten Hochtemperaturschrittes;
- Fig. 5: das Halbleitersubstrat nach dem zweiten Hochtemperaturschritt und weiteren Schritten zur Erzeugung und Kontaktierung aktiver Bereiche;
- Fig. 6: einen ersten optionalen Zwischenschritt zur Herstellung eines DMOS-Transistors mit einer Driftzone, die durch einen Graben begrenzt wird;
- Fig. 7: einen zugehörigen zweiten Zwischenschritt;
- Fig. 8: einen optionalen weiteren Zwischenschritt zur Erzeugung einer dotierten Driftzone für einen DMOS-Transistor; und
- Fig. 9: einen zugehörigen weiteren Schritt.

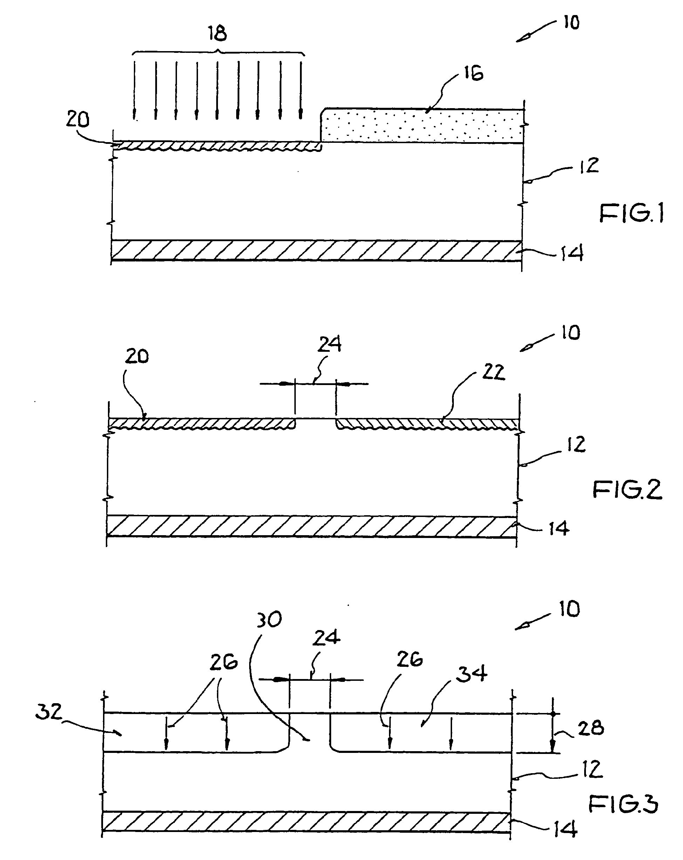

Die Figur 1 zeigt einen Teilquerschnitt eines Halbleiterkörpers 10, der ein Halbleitersubstrat 12 auf einer isolierenden Zwischenschicht 14 (Isolierschicht) aufweist. Ein typisches Beispiel eines solchen Halbleiterkörpers 10 wird durch einen "silicon on insulator"-Wafer (SOI-Wafer) repräsentiert. Dabei wird die isolierende Zwischenschicht 14 in der Regel als Siliziumdioxid-Schicht realisiert sein. Zur Erzeugung von Wannen mit unterschiedlicher Leitfähigkeit der jeweiligen Majoritätsladungsträger werden Teilbereiche des halbleitenden Substrates 12 mit Dotierstoffen unterschiedlicher Wertigkeit dotiert, so dass sich in ihnen unterschiedliche Leitfähigkeitstypen einstellen.

Für eine P-Leitfähigkeit wird beispielsweise ein vierwertiges Halbleitersubstratmaterial wie Silizium mit Bor-Atomen dotiert, die im Siliziumgitter als dreiwertige Substitutionsstörstellen eingebaut werden und als Elektronen-Akzeptoren wirken. Analog wird eine N-Leitfähigkeit durch Dotieren eines beispielsweise vierwertigen Halbleitersubstrates mit Arsen oder Phosphor erzeugt, die als fünfwertige Substitutionsstörstellen in das aus vierwertigen Siliziumatomen aufgebaute Grundgitter eingebaut werden und als Elektronen-Donatoren wirken.

Zur Definition der Wannengebiete werden Bereiche, die nicht dotiert werden sollen, durch eine Maske 16 abgedeckt. Das Einbringen der Dotierstoffe in die nicht durch die Maske 16 abgedeckten Bereiche kann prinzipiell nach einer Diffusionstechnik oder mit einer Ionenstrahlimplantation erfolgen. In der Regel wird bei modernen Herstellungsverfahren die Ionenstrahlimplantation bevorzugt, bei der eine genau kontrollierte Menge an Dotieratomen zunächst einheitlich ionisiert und auf eine definierte Ionengeschwindigkeit gebracht wird. In der Fig. 1 wird ein Strahl aus solchen ionisierten Dotieratomen durch die Pfeile 18 repräsentiert.

Der Strahl 18 aus Dotier-Ionen trifft auf nicht durch die Maske 16 abgedeckte Teilbereiche des halbleitenden Substrates 12 und dringt in dessen Gitter ein. Dort werden die Ionen abgebremst. Die Eindringtiefe hängt von der kinetischen Energie der Ionen ab. Durch die Energieabgabe schädigen die Ionen den Kristall und kommen zunächst meist auf Zwischengitterplätzen zur Ruhe. Nach der Implantation in eine oberflächennahe Schicht 20 des Halbleitersubstrates 12 sind deshalb Ausheil- und Aktivierungsschritte bei erhöhter Temperatur notwendig, um Schäden zu beseitigen und möglichst alle Dotieratome auf Gitterplätze im Volumen des Halbleitersubstrates zu bringen. Es ist ein wesentliches Merkmal der Erfindung, dass diese Ausheil- und Aktivierungsschritte nicht direkt auf die Implantation folgen, sondern erst nach weiteren Strukturierungsschritten durchgeführt werden.

In der Figur 1 repräsentiert die vergleichsweise dünne Schicht 20 die durch eine vorhergehende Implantation mit Dotierstoffatomen angereicherte Oberflächenschicht des Halbleitersubstrates 12. Dabei steht die von links unten nach rechts oben verlaufende Schraffur der Schicht 20 für einen bestimmten Leitfähigkeitstyp der Dotierung, beispielsweise eine P-Leitfähigkeit. Die vergleichsweise große Dichte der Schraffierung repräsentiert eine hohe Dotierstoffkonzentration.

Fig. 2 zeigt schematisch das Halbleitersubstrat 12 nach einer Implantation von Dotierstoffen unterschiedlicher Polarität als Basis einer Definition von zwei Wannen in dem Halbleitersubstrat 12. Dazu erfolgt im Anschluss an eine Implantation einer P-Wannen-Dotierung in einem weiteren Maskenschritt ein Abdecken der ersten Oberflächenschicht 20 durch eine weitere Maske und das Erzeugen einer zweiten Oberflächenschicht 22 durch Implantieren von Dotier-Ionen einer zweiten Leitfähigkeit, beispielsweise einer N-Leitfähigkeit. Die zweite Oberflächenschicht 22 wird bevorzugt so aufgebracht, dass sich ein lateraler Abstand 24 zwischen der ersten Oberflächenschicht 20 und der zweiten Oberflächenschicht 22 einstellt. Alternativ können beide Oberflächenschichten 20, 22 aber auch aneinander angrenzen oder sich überdecken. In diesem Fall würden sich die Donatoren und Akzeptoren in dem Überdeckungsbereich neutralisieren.

Auch die zweite Oberflächenschicht 22 wird bevorzugt nach einem Ionenimplantationsverfahren durch Beschießen der nicht durch die zweite Maske abgedeckten Oberflächenbereiche des Halbleitersubstrates 12 mit Dotierstoffionen des zweiten Leitfähigkeitstyps erzeugt.

Zum Abdecken der Bereiche, die bei den verschiedenen Implantationsschritten nicht dotiert werden sollen, eignen sich zum Beispiel dielektrische Materialien, die auch bei der Diffusionstechnik eingesetzt werden, wie Siliziumoxid und Siliziumnitrid. Die Ionenabbremsung in Festkörpern ist aber im Gegensatz zur Diffusion kein thermodynamischer, sondern im Wesentlichen ein mechanischer Prozess. Daher kann als Maskenmaterial jedes Material eingesetzt werden, das eine solche mechanische Abbremsung ermöglicht. Da bei der Ionenimplantation keine hohen Temperaturen auftreten, kann insbesondere der belichtete und entwickelte Fotolack selbst als Maskenmaterial, das heißt als Schutzschicht gegen implantierte Ionen verwendet werden. Da bei Masken 16 aus Fotolack keine separaten Temperaturschritte zur Erzeugung von Schutzschichten nötig sind, wie sie etwa bei der Abscheidung von Oxiden und Nitriden erforderlich sind, wird die Scheibendurchlaufzeit und die thermische Belastung der Wafer minimiert.

Die Masken 16 werden daher bevorzugt lithografisch als Fotolackschicht definiert. Durch einen Ätzschritt werden belichtete oder nicht belichtete Lackfenster bis zur Oberfläche des halbleitenden Substrates 12 freigeätzt. Anschließend erfolgt ein Belegen der freien Oberfläche des halbleitenden Substrates 12 mit einem Streuoxid und die Dotierung durch die Ionenimplantation.

Alternativ dazu wird der Halbleiterkörper 10 zunächst mit einem Oxid überzogen, das später bei der Dotierung der Wannengebiete als Implantationsmaske dient. Die Wannenbereiche werden lithografisch mit Masken in einer Fotolackschicht definiert. Ein nasschemischer Ätzschritt öffnet das Oxid in den Lackfenstern bis zur Siliziumoberfläche. Nach einem Belegen der freien Siliziumoberfläche mit einem Streuoxid erfolgt eine Dotierung durch Ionenimplantation.

Nach der Ionenimplantation erfolgt in einem ersten Hochtemperaturschritt eine unvollständige Eindiffusion 26 der oberflächennah in Schichten 20, 22 implantierten Dotierstoffionen in die Tiefe des Halbleitersubstrates 12. Das Ergebnis eines ersten Hochtemperaturschrittes, in dem die Eindiffusion 26 bis zu einer Eindringtiefe 28 von etwa der Hälfte der Tiefe des Halbleitersubstrates 12 vorangetrieben wurde, ist in der Fig. 3 dargestellt, in der die Pfeile 26 die Hauptdiffusionsrichtung angeben. Im Allgemeinen wird die Temperatur und die Dauer des Hochtemperaturschritts bevorzugt so vorbestimmt, dass die Eindringtiefe 28 der Dotierstoffe im ersten Hochtemperaturschritt etwa ein Viertel bis drei Viertel der gesamten, in allen Hochtemperaturschritten erzielten Eindringtiefe beträgt.

Der laterale Abstand 24 zwischen den Oberflächenschichten 20 und 22 ist bevorzugt so bemessen, dass sich bei der Eindiffusion 26 ein von Wannen-Dotierstoffen freibleibender Zwischenraum 30 zwischen den sich ausbildenden Wannen 32 und 34 ausbildet. Bei einer intrinsischen P-Leitfähigkeit des Halbleitersubstrates 12 oder einer P-Grunddotierung des Halbleitersubstrates 12 bezeichnet man diesen Zwischenraum 30 auch als P-body. Wie bereits erwähnt, trägt ein P-Body 30 zu einer erhöhten Durchbruchspannung bei.

Es versteht sich, dass die Erfindung nicht auf die Durchführung von genau zwei Hochtemperaturschritten beschränkt ist, sondern auch mehr als jeweils einen ersten und einen zweiten Hochtemperaturschritt umfassen kann. Dabei werden alle Hochtemperaturschritte, die vor einer Erzeugung von Grabenstrukturen durchgeführt werden, als erste Hochtemperaturschritte verstanden. Analog umfasst der Begriff der zweiten Hochtemperaturschritte alle Hochtemperaturschritte, die nach einer Erzeugung von grabenförmigen Strukturen durchgeführt werden.

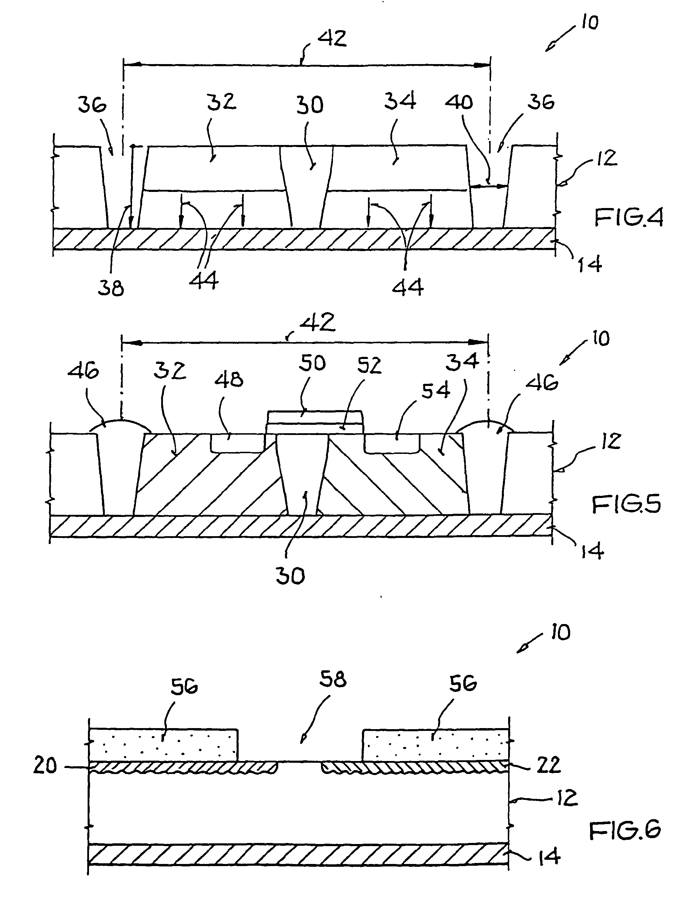

Die weitere Erläuterung bezieht sich zunächst auf die Fig. 4. Im Rahmen eines ersten Ausführungsbeispiels erfolgt anschließend ein Schritt, in dem tiefe Gräben 36 in dem Halbleitersubstrat 12 erzeugt werden. Dabei gilt ein Graben 36 dann als tief, wenn seine Tiefe 38 größer als seine Breite 40 ist. Die tiefen Gräben 36 werden durch einen Nass-Ätzprozess oder einen Trocken-Ätzprozess in Verbindung mit einem Maskenschritt erzeugt und reichen bei einem SOI-Wafer bevorzugt bis auf die Isolierschicht 14 herunter und definieren Bauelementboxen 42, in denen in späteren Verfahrensschritten aktive Bereiche erzeugt werden.

Nach der Erzeugung der tiefen Gräben 36 wird wenigstens ein zweiter Hochtemperaturschritt durchgeführt, in dem die Dotierstoffe für die Dotierung der Wannen 32, 34 vollständig in das Halbleitersubstrat 12 eingetrieben werden. Diese weitestgehend vollständige Eindiffusion 44 wird in der Fig. 4 durch die Pfeile 44 repräsentiert. Dabei ist bevorzugt, dass die Wannen 32, 34 bei einem Halbleiterkörper 10 mit einem Halbleitersubstrat 12 auf einer Isolierschicht 14 durch die Eindiffusion 44 bis zur Isolierschicht 14 hinunter getrieben werden. Das Ausdehnen der Wannen 32, 34 bis hinunter auf eine isolierende Zwischenschicht 14 eines SOI-Wafers 10 liefert in Verbindung mit der geringen Dicke des Halbleitersubstrates 12 den Vorteil, dass parasitäre Kapazitäten unterdrückt werden.

Das Ergebnis dieses Hochtemperaturschrittes ist in der Figur 5 dargestellt, in der die Schraffurrichtungen in den Wannen 32 und 34, wie auch bereits die Schraffurrichtungen der Oberflächenschichten 20 und 22 in den Figuren 1 und 2, den resultierenden Leitfähigkeitstyp anzeigen, der die Leitfähigkeit in dem betreffenden Bereich dominiert. Im Beispiel der Figur 5 hat sich links eine P-Wanne 32 und rechts eine N-Wanne 34 durch den Diffusionsprozess gebildet. Die Dichte der Schraffur steht dabei in einem umgekehrten Verhältnis zur Konzentration der Dotierstoffatome im halbleitenden Substrat 12. Während diese Konzentration in den ursprünglichen oberflächlichen Dotierschichten 20 und 22 noch vergleichsweise groß war, hat sich die Konzentration der Dotierstoffe durch eine Verteilung über annähernd das ganze Volumen des halbleitenden Substrates 12 innerhalb der Bauelementbox 42 verringert. Das Eintreiben durch die Eindiffusion 44 in einer zweiten Hochtemperaturphase wird bevorzugt so lange aufrechterhalten, bis sich eine gute Gleichverteilung der Dotierstoffe bis an die Grenzen der grabenförmigen Struktur 36 ausgebildet hat. Durch die Diffusion der zunächst auf Zwischengitterplätze implantierten Dotierstoffatome auf reguläre Gitterplätze werden die Dotierstoffatome aktiviert. Durch diesen Vorgang und durch Platzwechselvorgänge der Atome des Wirtsgitters findet darüber hinaus ein Ausheilen der durch den Ionenbeschuss hervorgerufenen Strahlenschäden in dem Wirtsgitter des Halbleitersubstrats 12 statt.

In diesem Verfahrensstadium sind nebeneinander liegende Bauelementboxen 42 an der Unterseite des Halbleitersubstrates 12 durch die Isolierschicht 14 gegeneinander isoliert. In der Tiefe des halbleitenden Substrates 12 sind sie durch tiefe Gräben 36 gegeneinander isoliert. Um eine gute Isolierung auch an der Oberfläche des halbleitenden Substrates 12 zu erzielen, wird anschließend die Grabenstruktur 36 mit einem dielektrischen Material 46 beispielsweise Siliziumdioxid, Siliziumnitrid, Polysilizium oder einem Mehrschichtsystem aus diesen Materialien gefüllt. Das Auffüllen durch Oxidation kann selbstverständlich bereits parallel zum Hochtemperaturschritt des vollständigen Eintreibens der Dotierstoffatome in die Tiefe des halbleitenden Substrates 12 durchgerührt werden.

Das in der Figur 5 dargestellte Ergebnis repräsentiert einen Halbleiterkörper 10, bei dem verschieden dotierte Wannenbereiche 32, 34 durch einen P-Body 30 voneinander getrennt in einer Bauelementbox 42 angeordnet sind. Durch Implantieren weiterer Dotierungen werden anschließend zum Beispiel ein Source-Anschluss 48, ein Gate-Anschluss 50 auf einem Gate-Oxid 52 und ein Drain-Anschluss 54 erzeugt, um einen DMOS-Transistor bereitzustellen. Es versteht sich, dass die Herstellung eines realen DMOS-Transistors weitere Schritte umfassen kann, wie eine CMP (chemical mechanical polishing) - Planarisierung, eine Extension-Implantation, eine Schwellspannungsimplantation, eine Gate-Oxidation, eine Gate-Polyabscheidung und Strukturierung (Maskenschritt), LDD-Implantationen (LDD = lightlydoped-drain, Maskenschritte), Source/Drain Implantationen (Maskenschritt), eine BPSG-Abscheidung (BPSG = Bor-Phosphor-Silikat-Glas) , Kontaktfensterätzungen und Metallisierungen ).

Mit Blick auf die Figuren 1 bis 5 wurde eine erste Prozessfolge mit folgenden Schritten erläutert: Ausgehend von einem SOI-Wafer als Startmaterial erfolgt in einem ersten Schritte eine Implantation eines P-Wannen-Dotierstoffs und in einem zweiten Schritt eine Implantation eines N-Wannen-Dotierstoffs, bevorzugt mit lateralem Abstand 24 zum P-Wannendotierstoff. Anschließend erfolgt in einem dritten Schritt eine erste Eindiffusion 26 (erster Hochtemperaturschritt), bevor in einem vierten Schritt eine Grabenstruktur in Form von tiefen Gräben 36 erzeugt wird. Danach erfolgt in einem fünften Schritt eine zweite Eindiffusion 44 und in weiteren sechsten und siebten Schritten ein Füllen der Grabenöffnungen mit einem Dielektrikum 46 und ein Erzeugen aktiver Bereiche in den Wannen 32, 34.

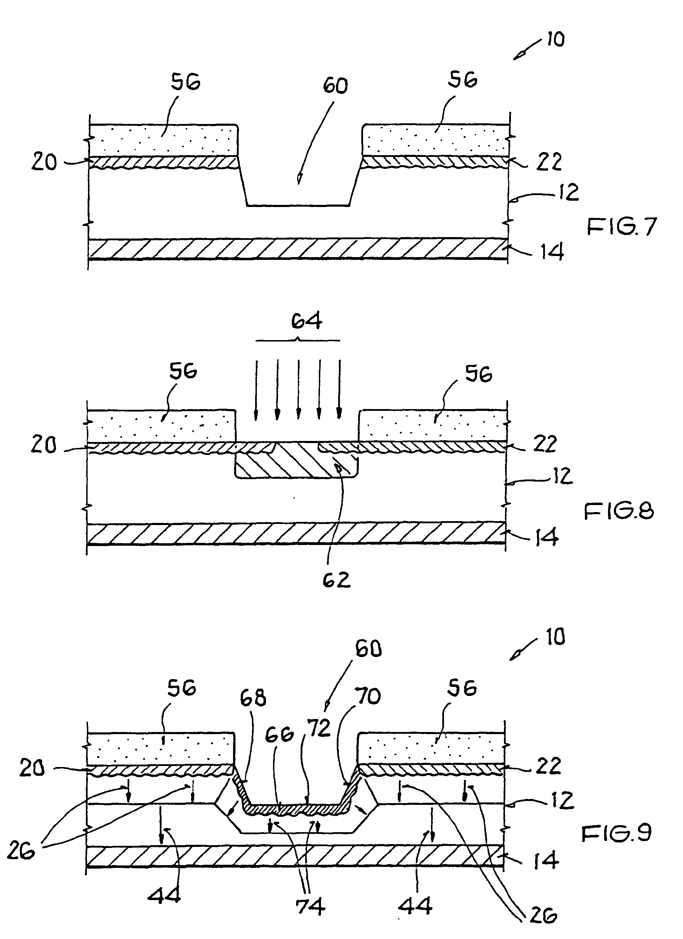

Im Folgenden werden mit Bezug auf die Figuren 6 und 7 sowie auf die Figuren 8 und 9 weitere Ausgestaltungen erläutert, bei denen ein DMOS-Transistor mit grabenrand-förmiger Driftzone ohne (Fig. 6, 7) und mit gesonderter Dotierung der Driftzone (Fig. 8, 9) als Halbleiterbauelemente erzeugt werden.

Die Ausgestaltung nach den Figuren 6 und 7 basiert auf den ersten beiden oben beschriebenen Schritten, die mit Bezug auf die Figuren 1 und 2 erläutert wurden. Nach der Implantation der Dotierstoffe in Oberflächenschichten 20 und 22 wird eine Maske 56 erzeugt. Dabei kann es sich um eine Lackmaske oder um eine Hartmaske, beispielsweise aus Siliziumnitrid, handeln. Anschließend wird die Maske 56 über dem optional vorhandenen Zwischenraum 30 zwischen den Oberflächenschichten 20 und 22 geöffnet und in der Öffnung 58 wird eine Grabenstruktur in dem halbleitenden Substrat 12 erzeugt, was beispielsweise durch eine anisotrope STI-Ätzung (shallow trench isolation) erreicht werden kann. Diese Grabenstruktur ist in der Fig. 7 dargestellt. Bei der "shallow trench isolation"-Technologie werden durch einen anisotropen Ätzprozess Gräben zwischen den mit der Maske bedeckten Bereichen erzeugt und später mit einem isolierenden Material wie Siliziumdioxid oder Polysilizium aufgefüllt.

Dabei gilt ein Graben bei einem Aspektverhältnis, also einem Verhältnis von Grabentiefe zu Grabenbreite, das kleiner oder gleich eins ist, als flach im Sinne der namensgebenden Beschreibung. Durch den Graben 60 wird unter anderem ein definierter räumlicher Abstand zwischen der ersten Dotierschicht 20 und der zweiten Dotierschicht 22 erzeugt. Darüber hinaus werden durch das Ausheben des Grabens 60 Dotierunschärfen, die sich aus einer unerwünschten Überlappung der Oberflächenschichten 20 und 22 ergeben können, beseitigt.

Der fertige Graben ist in der Fig. 7 dargestellt. Anschließend folgen weitere Schritte, wie sie im Zusammenhang mit den Figuren 3 bis 6 bereits erläutert worden sind. Das heißt, es folgt zunächst ein erster Hochtemperaturschritt, eine Erzeugung tiefer Gräben als Grenzen von Bauelementboxen, ein zweiter Hochtemperaturschritt und eine Erzeugung und Kontaktierung aktiver Bereiche. Dabei kann der erste Hochtemperaturschritt auch vor der Erzeugung des flachen Grabens 60 erfolgen. Dadurch, dass zumindest ein Hochtemperaturschritt nach der STI-Ätzung durchgeführt wird, können bei der Ätzung entstandene Defekte noch bis zu einem gewissen Grad ausheilen. Dies wäre jedoch nicht der Fall, wenn die Eindiffusion der Wannendotierung nur in einem einzigen Hochtemperaturschritt nach der Erzeugung der tiefen Gräben erfolgen würde, weil eine einzige entsprechend lange Hochtemperaturphase neue Defekte hervorrufen kann.

Durch diese Ausgestaltung mit dem flachen Graben 60 wird ein DMOS-Transistor ohne gesonderte Dotierung der Driftzone bereitgestellt. Dadurch wird insbesondere die Durchbruchspannung des DMOS-Transistors in erwünschter Weise erhöht.

Als weitere Alternative kann ein Verfahren zur Herstellung eines DMOS-Transistors mit einer gesondert dotierten Driftzone durch die Erfindung verbessert werden. Für die Herstellung eines solchen Transistors werden zunächst die bereits mit Bezug auf die Figuren 1, 2, und 6 beschriebenen Schritte durchgeführt. Anschließend wird durch die geöffnete Maske 56 ein Dotierprofil unter der Öffnung 58 durch Implantieren von Dotierstoffen erzeugt, wie es in der Fig. 8 schematisch dargestellt ist. Dabei kann die Implantation senkrecht von oben oder unter einem Tiltwinkel erfolgen, um eine Vorzugsrichtung bei der Implantation zu definieren. In der Fig. 8 repräsentieren die Pfeile 64 einen Dotier-Ionenstrahl, der unter einem Tiltwinkel einfällt. Dadurch kann zum Beispiel bei einer späteren Anordnung eines Drain-Bereiches auf der rechten Seite eine verstärkte Dotierung der Driftzone in der Nähe des Drain-Bereiches erreicht werden.

Anschließend wird in dem Dotierprofil 62 durch einen STI-Prozess ein Graben erzeugt. Dabei wird die Ätzung so betrieben, dass ein Rand 66 des Dotierprofils 62 an Seitenwänden 68, 70 und/oder am Boden 72 des Grabens erhalten bleibt, bevor der zweite Hochtemperaturschritt zur vollständigen Eindiffusion 44 der Wannendotierung durchgeführt wird. Durch diesen zweiten Hochtemperaturschritt erfolgt parallel zum Eintreiben der Wannendotierung eine Eindiffusion 74 von Dotierstoffen aus dem Rand 66 des Grabens in das umliegende Volumen des Halbleitersubstrates 12. Die erste Eindiffusion 26 erfolgt vor der STI-Ätzung.

Die Verbesserung gegenüber bekannten Verfahren zur Herstellung von DMOS-Transistoren ohne gesondert dotierte Driftzone besteht darin, dass das Aufteilen der Diffusionsschritte (Hochtemperaturschritte) zur optimalen Einstellung des Dotierprofils in der Driftzone verwendet werden kann, um zum Beispiel einen RESURF-Effekt zu optimieren.

Das erfindungsgemäße Verfahren kann auch zur Herstellung von Wannen in sogenannten bulk-Substraten verwendet werden. In diesem Fall, in dem die Wannen nicht bis auf eine Isolatorschicht hinunterreichen, werden die tiefen Gräben bevorzugt tiefer als die Wannentiefe ausgeätzt.

Das Risiko einer späteren Defektstellenbildung am Rand der Gräben bei nachfolgenden Hochtemperaturschritten kann durch die Ausbildung einer dünnen Oxidschicht, eines Lineroxides, auf der Oberfläche der Grabenstruktur verringert werden.

## Patentansprüche

1. Verfahren zur Herstellung von Halbleiterbauelementen in einem Halbleitersubstrat (12) mit den Schritten: Erzeugen von Wannen (32, 34) mit unterschiedlichem Leitfähigkeitstyp und Erzeugen von grabenförmigen Strukturen (36, 60) innerhalb des Halbleitersubstrates (12), wobei die Wannen (32, 34) durch eine Implantation und eine Eindiffusion (26, 44) von Dotierstoffen erzeugt werden, und Erzeugen und Kontaktieren von aktiven Bereichen in dem Halbleitersubstrat (12), bei dem die Eindiffusion (26, 44) durch wenigstens zwei Hochtemperatwschritte erfolgt, wobei wenigstens eine erste Eindiffusion (26) durch einen ersten Hochtemperaturschritt vor einem Erzeugen der grabenförmigen Strukturen (36, 60) durchgeführt wird und wobei wenigstens eine zweite Eindiffusion (44) durch einen zweiten Hochtemperaturschritt nach dem Erzeugen der grabenförmigen Strukturen (36, 60) durchgeführt wird.

2. Verfahren nach Anspruch 1, bei dem wenigstens ein Teil der grabenförmigen Strukturen (36, 60) durch tiefe Gräben (36) gebildet wird, die Bauelementboxen (42) voneinander isolieren, die innerhalb des Halbleitersubstrates angeordnet (12) sind.

3. Verfahren nach Anspruch 2, bei dem die tiefen Gräben (36) bis hinunter zu einer Isolierschicht (14) reichen, auf der sich das Halbleitersubstrat (12) erstreckt.

4. Verfahren nach wenigstens einem der vorhergehenden Ansprüche, bei dem wenigstens ein Teil der grabenförmigen Strukturen (36, 60) durch flache Gräben (60) gebildet wird, die eine Driftzone eines DMOS-Transistors teilweise begrenzen.

5. Verfahren nach Anspruch 4, bei dem der flache Graben (60) durch einen STI-Prozess erzeugt wird.

6. Verfahren nach Anspruch 4 oder 5, bei dem Seitenwände (68, 70) und/oder Bodenbereiche (72) des flachen Grabens (60) gesondert dotiert werden.

7. Verfahren nach Anspruch 6, bei dem die Dotierung durch wenigstens eine vor dem zweiten Hochtemperaturschritt erfolgende Implantation und eine während des zweiten Hochtemperaturschrittes erfolgende Eindiffusion (74) erfolgt.

8. Verfahren nach wenigstens einem der vorhergehenden Ansprüche, bei dem eine Implantation eines zweiten Dotierstoffes für eine zweite Wanne (34) in einen zweiten Bereich erfolgt, der einen lateralen Abstand (24) zu einem ersten Bereich besitzt, in den eine Implantation eines ersten Dotierstoffes für eine erste Wanne (32) erfolgt.

9. Verfahren nach Anspruch 8, bei dem die Eindiffusion (26, 44) so erfolgt, dass zwischen den Wannen (32, 34) nach den Hochtemperaturschritten ein Bereich (30) mit einer Grunddotierung oder mit intrinsischer Leitfähigkeit bestehen bleibt.

10. Verfahren nach wenigstens einem der vorhergehenden Ansprüche, bei dem die grabenförmigen Strukturen (36, 60) mit einem Dielektrikum (46) gefüllt werden.

11. Verfahren nach Anspruch 10, bei dem als Dielektrikum (46) ein Oxid des Halbleitersubstratmaterials, ein Nitrid des Halbleitersubstratmaterials, polykristallines Material aus Bestandteilen des Halbleitersubstratmaterials oder Mehrschichtsysteme aus den genannten Materialien verwendet wird.

## Claims

1. Method of producing semiconductor components in a semiconductor substrate (12) comprising the steps: producing troughs (32, 34) with different conductivity type and producing trench-shaped structures (36, 60) within the semiconductor substrate (12), wherein the trenches (32, 34) are produced by implantation and inward diffusion (26, 44) of doping substances, and producing and contacting active regions in the semiconductor substrate (12), in which the inward diffusion (26, 44) takes place by at least two high-temperature steps, wherein at least one first inward diffusion (26) is carried out by a first high-temperature step before production of the trench-shaped structures (36, 60) and wherein at least one second inward diffusion (44) is carried out by a second high-temperature step after production of the trench-shaped structures (36, 60).

2. Method according to claim 1, in which at least a part of the trench-shaped structures (36, 60) is formed by deep trenches (36), which insulate component boxes (42), which are arranged within the semiconductor substrate (12), from one another.

3. Method according to claim 2, in which the deep trenches (36) reach down to an insulating layer (14) on which the semiconductor substrate (12) extends.

4. Method according to at least one of the preceding claims, in which at least a part of the trench-shaped structures (36, 60) is formed by flat trenches (60) which partly bound a drift zone of DMOS transistor.

5. Method according to claim 4, in which the flat trench (60) is formed by an STI process.

6. Method according to claim 4 or 5, in which the side walls (68, 70) and/or base regions (72) of the flat trench (60) are separately doped.

7. Method according to claim 6, in which the doping is carried out by at least one implantation taking place before the second high-temperature step and an inward diffusion (74) taking place during the second high-temperature step.

8. Method according to at least one of the preceding claims, in which an implantation of a second doping substance for a second trough (34) is carried out in a second region having a lateral spacing (24) from a first region in which an implantation of a first doping substance for a first trough (32) is carried out.

9. Method according to claim 8, in which the inward diffusion (26, 44) is so carried out that a region (30) with a basic doping or with intrinsic conductivity remains between the troughs (32, 34) after the high-temperature steps.

10. Method according to at least one of the preceding claims, in which the trench-shaped structures (36, 60) are filled with a dielectric (46).

11. Method according to claim 10, in which an oxide of the semiconductor substrate material, a nitride of the semiconductor substrate material, polycrystalline material of constituents of the semiconductor substrate material or multi-layer systems of the said materials is or are used as dielectric (46).

## Revendications

1. Procédé de fabrication de composants semi-conducteurs dans un substrat semi-conducteur (12) comprenant les étapes suivantes : formation de cuvettes (32, 34) présentant des types de conductivité différents et formation de structures en forme de tranchées (36, 60) à l'intérieur du substrat semi-conducteur (12), les cuvettes (32, 34) étant formées par une implantation et une diffusion (26, 44) de produits dopants, et formation de zones actives dans le substrat semi-conducteur (12) et mise en contact de ces zones, dans lequel la diffusion (26, 44) s'effectue grâce à au moins deux étapes à température élevée, une première diffusion (26) au moins étant réalisée grâce à une première étape à température élevée avant la formation des structures en forme de tranchées (36, 60), et une deuxième diffusion (44) au moins étant réalisée grâce à une deuxième étape à température élevée après la formation des structures en forme de tranchées (36, 60).

2. Procédé selon la revendication 1, dans lequel une partie au moins des structures en forme de tranchées (36, 60) est formée par des tranchées profondes (36) qui isolent les uns des autres des boites de composants (42) qui sont disposées à l'intérieur du substrat semi-conducteur (12).

3. Procédé selon la revendication 2, dans lequel les tranchées profondes (36) descendent jusqu'à une couche d'isolation (14) sur laquelle s'étend le substrat semi-conducteur (12).

4. Procédé selon l'une au moins des revendications précédentes, dans lequel une partie au moins des structures en forme de tranchées (36, 60) est formée de tranchées plates (60) qui délimitent partiellement une zone de dérive d'un transistor DMOS.

5. Procédé selon la revendication 4, dans lequel la tranchée plate (60) est réalisée par un procédé STI.

6. Procédé selon la revendication 4 ou 5 dans lequel on dope séparément les parois latérales (68, 70) et/ou les zones de fond (72) de la tranchée plate (60).

7. Procédé selon la revendication 6, dans lequel le dopage est réalisé par au moins une implantation effectuée avant la deuxième étape à température élevée et par une diffusion (74) effectuée durant la deuxième étape à température élevée.

8. Procédé selon l'une au moins des revendications précédentes, dans lequel on réalise l'implantation d'un deuxième produit dopant pour une deuxième cuvette (34) dans une deuxième zone située latéralement à distance (24) d'une première zone dans laquelle on réalise l'implantation d'un premier produit dopant pour une première cuvette (32).

9. Procédé selon la revendication 8, dans lequel on réalise la diffusion (26, 44) de telle façon qu'après les étapes à température élevée, il reste entre les cuvettes (32, 34) une zone (30) présentant un dopage de base ou une conductivité intrinsèque.

10. Procédé selon l'une au moins des revendications précédentes, dans lequel les structures en forme de tranchées (36, 60) sont remplies d'un diélectrique (46).

11. Procédé selon la revendication 10, dans lequel on utilise comme diélectrique (46) un oxyde du matériau composant le substrat semi-conducteur, un nitrure du matériau composant le substrat semi-conducteur, un matériau polycristallin formé d'éléments du matériau composant le substrat semi-conducteur ou des systèmes multicouches formés des matériaux précités.
